# EUROPÄISCHE PATENTSCHRIFT

(11) **EP 2 725 435 B1**
(45) Veröffentlichungstag und Bekanntmachung des Hinweises auf die Patenterteilung: **10.12.2014**
(21) Anmeldenummer: 12007295.4
(22) Anmeldetag: 24.10.2012
(51) Int. Cl.: G05B 9/02, H03K 17/78, H02P 29/02

(54) **Steuerung einer Sicherheitsfunktion einer elektrischen Maschine**
Control of a security feature of an electric machine
Commande d'une fonction de sécurité d'une machine électrique

(43) Veröffentlichungstag der Anmeldung: 30.04.2014
(73) Patentinhaber: Baumüller Nürnberg GmbH, 90482 Nürnberg (DE)
(72) Erfinder: Hensel, Uwe, 90411 Nürnberg (DE); Dimas-Zekri, Magdi, 90478 Nürnberg (DE); Helmerth, Axel, 57234 Wilnsdorf (DE)
(74) Vertreter: FDST Patentanwälte

(56) Entgegenhaltungen:
- EP-A2- 2 495 869
- US-A- 6 023 178
- US-A1- 2010 327 667
- ABB: "Applikationsanleitung für die Funktion Sicher abgeschaltetes Moment Safe Torque Off (STO-Funktion)", 1. Oktober 2007 (2007-10-01), ABB HANDBOOKS - ACSM1 FREQUENZUMRICHTER HANDBÜCHER,, PAGE(S) 1 - 18, XP002512330, * das ganze Dokument *

## Beschreibung

Die Erfindung betrifft ein Verfahren zur Steuerung einer Sicherheitsfunktion einer mittels eines Frequenzumrichters betriebenen oder versorgten elektrischen Maschine, gemäß dem Oberbegriff des Anspruchs 1. Sie betrifft weiter eine Vorrichtung zur Durchführung des Verfahrens, wobei unter Sicherheitsfunktion insbesondere die sogenannte Safe-Torque-Funktion (STO) verstanden wird. Ein derartiges Verfahren und eine entsprechende Vorrichtung sind aus der EP 2 495 869 A2 bekannt.

Im Bereich der Antriebstechnik mit elektrischen Maschinen, insbesondere mit Synchron- oder Asynchronmotoren, sind sicherheitsgerichtete Funktionen gefordert, um Verletzungen infolge von ungewollten oder unerwarteten Drehungen der Antriebe zuverlässig zu vermeiden. Eine wesentliche Sicherheitsfunktion ist hierbei ein als Safe-Torque-Off (STO) bezeichneter sicherer Halt des Antriebs, indem dieser sicher von dessen Energieversorgung getrennt wird, um nach Auslösung der Sicherheitsfunktion auszutrudeln und - in Abhängigkeit der Drehzahl und des angeschlossenen Drehmoments - seine Ruhelage zuverlässig zu erreichen.

Bei üblicherweise mit Frequenzumrichtern gesteuert gespeisten Drehstrommotoren erfolgt die Steuerung bzw. Auslösung der oder jeder Sicherheitsfunktion am Frequenzumrichter, in dem dieser und damit auch der Drehstrommotor bzw. die elektrische Maschine von der Energieversorgung getrennt wird. Zur Energieversorgung des Frequenzumrichters dient üblicherweise eine 24V-DC-Eingangsspannung, die dem Frequenzumrichter über einen Schalter, beispielsweise ein Relais, zugeführt wird. Wird der Schalter im Zuge einer Stop-Funktion zur Abschaltung der Maschine betätigt, so wird die zur Steuerung des Frequenzumrichters benötigte Eingangsspannung und damit dessen Versorgung abgeschaltet.

Hierzu ist aus der US 7,868,619 B2 eine Safe-Torque-Off-Verbindung (STO-Funktion) bekannt, bei der die 24V-Eingangsspannung für die Steuereinrichtung sowie für die von dieser angesteuerten Treiber der Leistungs- oder Leistungshalbleiterschalter des Frequenzumrichters mittels eines zweipoligen Schalters und damit die Stromversorgung für die elektrische Maschine sicher unterbrochen wird.

Aus der eingangs genannten EP 2 495 869 A2 ist ein Steuergerät in Form eines Frequenzumrichters mit STO-Funktion für einen Elektromotor mit einem ersten galvanisch trennenden Übertragungsmittel bekannt, das nur bei Anliegen einer Versorgungsspannung ein Ausgangssignal zur Ansteuerung von Leistungshalbleitern (IGBT's) des die Betriebsspannung für einen Elektromotor bereitstellenden Frequenzumrichters erzeugt. Eine hierzu vorgesehene Einrichtung umfasst einen Schwingkreis, dessen Versorgungsspannung von einem Aktuatorsignal abhängig ist, das seinerseits einen zulässigen Betriebszustand des Elektromotors signalisiert. Das Schwingkreissignal wird über ein zweites Übertragungsmittel an eine Verstärker- und Entkopplungsschaltung sowie an einen Gleichrichter übertragen, der die Versorgungsspannung für das erste Übertragungsmittel zur Ansteuerung der Leistungshalbleiter erzeugt.

Der Erfindung liegt die Aufgabe zugrunde, ein verbessertes Verfahren und eine besonders geeignete Vorrichtung zur Steuerung einer Sicherheitsfunktion einer elektrischen Maschine anzugeben, wobei die Steuerung auch bei einer Eingangsspannung größer oder gleich 60V zuverlässig unter Gewährleistung der Sicherheitsfunktion, insbesondere bei gleichzeitig möglichst geringer Verlustleistung, arbeiten soll.

Diese Aufgabe wird erfindungsgemäß bezüglich des Verfahrens durch die Merkmale des Anspruchs 1 und bezüglich der Vorrichtung durch die Merkmale des Anspruchs 2 gelöst. Vorteilhafte Ausgestaltungen, Varianten und Weiterbildungen sind Gegenstand der Unteransprüche.

Hierzu wird aus einer Eingangsgleichspannung eine potentialgetrennte Ausgangsgleichspannung und aus dieser ein Steuersignal für den Frequenzumrichter zu dessen bestimmungsgemäßen Betrieb und zur Auslösung der Sicherheitsfunktion erzeugt. Zudem wird ein Ansteuersignal für einen periodisch an die Eingangsspannung geschalteten Halbleiterschalter erzeugt und die Ausgangsspannung reduziert oder begrenzt, wenn die Ausgangsspannung eine Schaltschwelle oder einen Schwellwert überschreitet.

Die Erfindung geht dabei von der Überlegung aus, dass zur Beherrschung auch eines relativ großen Spannungsbereichs der Eingangsspannung von größer oder gleich 60V zwar in einfachster Art und Weise eine Spannungsteilerschaltung, eventuell mit nachgeschaltetem Optokoppler zur galvanischen Trennung, eingesetzt werden könnte. Nachteilig bei derart hohen Eingangsspannungen ist jedoch die entsprechend hohe Verlustleistung an den ohmschen Widerständen des Spannungsteilers. Auch der Einsatz einer Konstantstromquelle mit eventuell nachgeschaltetem Optokoppler führt zu unerwünscht hohen Verlustleistungen bei einer entsprechend hohen Eingangsspannung in Höhe der geforderten 60V. Auch könnten bekannte Schaltungen zur Spannungsbegrenzung verwendet werden, um im Fehlerfall auftretende Spannungserhöhungen auf die 24V-Eingangsspannung zu begrenzen. Mit derartigen Spannungsbegrenzungsschaltungen ist jedoch nicht sichergestellt, dass die geforderte Sicherheitsfunktion unbeeinflusst gewährleistet und eine unerwünschte Abschaltung der Eingangsspannung zuverlässig verhindert ist.

Demgegenüber sind das erfindungsgemäße Verfahren und die erfindungsgemäße Vorrichtung dazu vorgesehen und eingerichtet, einen Betriebsfall mit einer erhöhten Eingangsspannung von beispielsweise 60V auch für einen Digitaleingang einer nachfolgenden Steuerschaltung für den Frequenzumrichter bei gleichzeitig geringer Verlustleistung zuzulassen und die geforderte Sicherheitsfunktion, insbesondere die STO-Funktion, zuverlässig zu gewährleisten.

Die Vorrichtung sieht hierzu eine getaktete Wandlerschaltung mit einem Transformator zur potentialgetrennten Energieübertragung vor, dem primärseitig ein ansteuerbarer Halbleiterschalter sowie sekundärseitig ein Gleichrichter zugeordnet ist. Die Wandlerschaltung ist hierbei schaltungstechnisch nach Art eines getakteten Spannungswandlers ausgeführt, der beispielsweise als Sperrwandler oder auch als Flusswandler arbeitet und die Eingangsgleichspannung, die im Normalfall 24V beträgt, in eine Ausgangsgleichspannung umwandelt, die einer Einrichtung zur Erzeugung eines Steuersignals für den Frequenzumrichter bereitgestellt ist.

Die dem Gleichrichter nachgeschaltete Einrichtung ist zudem schaltungs- und/- oder programmtechnisch dazu eingerichtet, ein getaktetes Ansteuersignal für den Halbleiterschalter der Wandlerschaltung zu erzeugen, wenn die Eingangsspannung und damit die Ausgangsspannung der Einrichtung einen vorgegebenen Maximalwert überschreitet. Infolge des Ansteuersignals wird die Ausgangsspannung, falls diese den Maximalwert überschreitet, steuer- oder regelungstechnisch begrenzt. Hierzu ist die Einrichtung über eine Rückführschleife, vorzugsweise mit galvanisch trennendem Element in Form insbesondere eines Optokopplers, mit dem Halbleiterschalter ansteuerseitig verbunden. Die Rückführschleife umfasst zweckmäßigerweise einen Pulsmodulator zur Einstellung der Arbeitsfrequenz des Halbleiterschalters anhand des von der Einrichtung erzeugten Takt- oder Ansteuersignals. Der Pulsmodulator ist dabei geeigneterweise ein Pulsweitenmodulator (PWM) und/oder ein Puls-Pausen-Modulator (PPM) zur Einstellung des Tastgrades des Takt- oder Ansteuersignals für den Halbleiterschalter.

Die Steuer- und/oder Regeleinrichtung weist vorzugsweise eine mit der Ausgangsspannung der Wandlerschaltung beaufschlagte Komparator- und Schwellwertschalterfunktion zur Aktivierung des Ansteuersignals für den Halbleiterschalter auf. Des Weiteren umfasst die Steuer- und/oder Regeleinrichtung geeigneterweise einen Soll-Ist-Vergleicher und einen diesem nachgeschalteten Pulsmodulator zur Einstellung der Arbeitsfrequenz des Halbleiterschalters anhand einer Abweichung der Ausgangsspannung von einem Sollwert.

In einer zweckmäßigen Ausgestaltung der Vorrichtung ist der Steuer- und/oder Regeleinrichtung ein Schmitt-Trigger als Schwellwertschalter nachgeschaltet oder zugeordnet, dem die Ausgangsspannung der Wandlerschaltung zur Erzeugung eines binären Steuersignals für den Frequenzumrichter zugeführt ist. Das Steuersignal führt vorzugsweise einen high-Pegel zum Betrieb des Frequenzumrichters, wenn die Ausgangsspannung einen oberen Schwellwert überschreitet, und einen die Sicherheitsfunktion auslösenden low-Pegel, wenn die Ausgangsspannung einen unteren Schwellwert unterschreitet.

Zweckmäßigerweise sind die Wandlerschaltung und die Steuer- und/oder Regeleinrichtung redundant ausgeführt. Zudem ist geeigneterweise die Funktionalität der Steuer- und/oder Regeleinrichtung, insbesondere deren Komparator- und Schwellwertschalterfunktion in zwei redundante Mikroprozessoren integriert, deren Eingänge für die Ausgangsspannung der Wandlerschaltung mit dem jeweils anderen Mikroprozessors gekoppelt sind.

Besonders bevorzugt ist der Halbleiterschalter steuerseitig über ein galvanisch trennendes Element in Form eines Optokopplers mit der Steuer- und/oder Regeleinrichtung verbunden. In einer besonders bevorzugten Variante der Wandlerschaltung bildet der oder bei redundanter Ausführung jeder Halbleiterschalter mit der Primärwicklung des Transformators eine Reihenschaltung, an der die Eingangsspannung anliegt. Der Reihenschaltung ist dann geeigneterweise ein Kondensator zur Pufferung der üblicherweise zumindest geringfügig schwankenden Eingangsspannung parallel geschaltet. An diesen Pufferkondensator ist dann zweckmäßigerweise der Steuereingang (Gate) des vorzugsweise als MOSFET ausgeführten Halbleiterschaler über den Fototransistor des galvanisch trennenden Optokopplers angeschlossen.

Die mit der Erfindung erzielten Vorteile bestehen insbesondere darin, dass unter Verwendung einer Wandlerschaltung zur Steuerung einer Sicherheitsfunktion einer elektrischen Maschine ein vergleichsweise großer oder weiter Eingangsspannungsbereich von mehr als 60V sicher und dabei insbesondere hinsichtlich der erfindungsgemäßen Vorrichtung eigensicher sowie bei nur geringer Verlustleistung beherrscht ist. Aufgrund des redundanten Aufbaus der Wandlerschaltung und der Einrichtung zur Auslösung der Sicherheitsfunktion, insbesondere der STO-Funktion, sowie deren gegenseitiger Überwachung ist die Sicherheit und Eigensicherheit der erfindungsgemäßen Vorrichtung weiter erhöht.

Nachfolgend werden Ausführungsbeispiele der Erfindung anhand einer Zeichnung näher erläutert. Darin zeigen:
- Fig. 1: schematisch in einem Blockschaltbild eine Vorrichtung zur Steuerung eines Frequenzumrichters einer elektrischen Maschine mit eingangsseitig einer Wandlerschaltung zur Auslösung einer Sicherheitsfunktion sowie zur Spannungsbegrenzung, und
- Fig. 2: den schaltungstechnischen redundanten Aufbau der Wandlerschaltung mit nachgeschalteter Einrichtung zur Auslösung der Sicherheitsfunktion mit gegenseitiger Überwachung.

Einander entsprechende Teile sind in beiden Figuren mit den gleichen Bezugszeichen versehen.

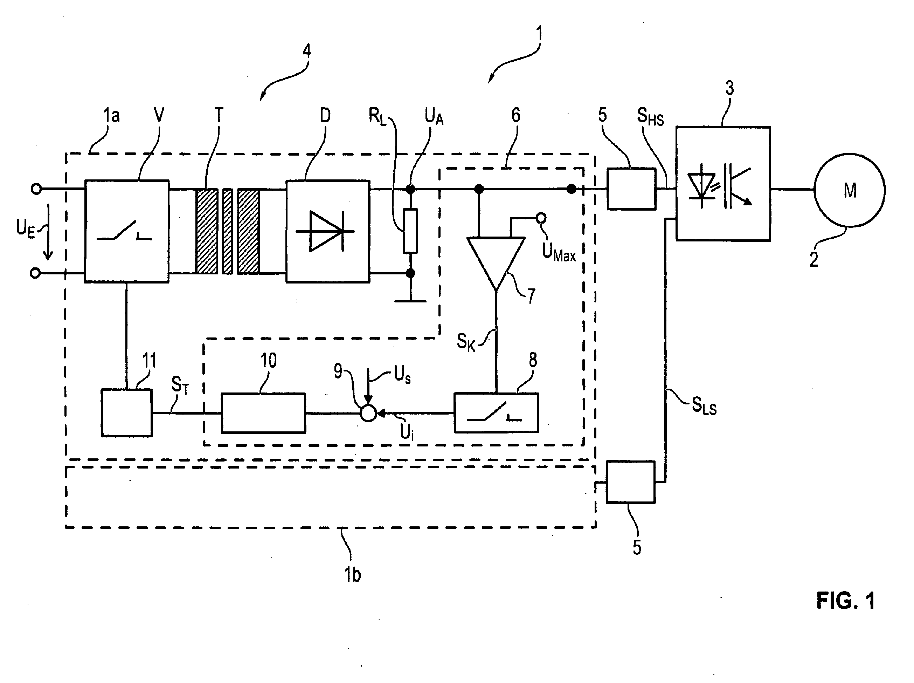

Fig. 1 zeigt eine Vorrichtung 1 zur Steuerung einer Sicherheitsfunktion, insbesondere der Safe-Torque-Off-Funktion (STO), eines Drehstrommotors 2 als elektrische Maschine, der mittels eines Frequenzumrichters 3 versorgt oder betrieben ist. Die Vorrichtung 1 umfasst eine getaktete Wandlerschaltung 4 mit einem Transformator T, dem primärseitigen ein Halbleiterschalter V vorgeschaltet und sekundärseitig ein Gleichrichter D nachgeschaltet ist. Die Wandlerschaltung 4 wandelt eine Eingangsgleichspannung U_{E} in eine Ausgangsgleichspannung U_{A} um, die an einem gegen Masse oder Bezugspotential geschalteten Lastwiderstand R_{L} abgreifbar ist. Die Spannungsumwandlung oder -umsetzung erfolgt mittels des mit einer bestimmten Schalt- oder Arbeitsfrequenz angesteuerten elektronischen Halbleiterschalters V sowie mittels des Transformators T zur potentialgetrennten Energieübertragung und mittels des Gleichrichters D zur Auskopplung der Ausgangsgleichspannung U_{A}.

Der Transformator T kann hierbei als Energiespeicher eines getakteten Sperrwandlers mit galvanischer Trennung zwischen dem Wandlereingang und dem Wandlerausgang oder auch als galvanisch trennendes Bauteil eines sogenannten Flusswandlers arbeiten. Bei beiden Wandlervarianten wird der Halbleiterschalter V regelmäßig gesteuert geöffnet, so dass sich das magnetische Feld im Transformator T abbauen kann. Die Eingangsspannung kann beispielsweise U_{E} = 24V bis U_{E} = 60V betragen.

Die Ausgangsspannung U_{A} wird an einen Schwellwertschalter 5 in Form vorzugsweise eines Schmitt-Triggers geführt, der ein binäres Steuersignal für den Frequenzumrichter 3 erzeugt. Übersteigt die Ausgangsspannung U_{A} einen oberen Schwellwert U₁, beispielsweise U₁ = 11V, so liefert der Schwellwertschalter 5 ein binäres Steuersignal S_{HS} mit einem High-Pegel, so dass der dem Schwellwertschalter 5 nachgeschaltete Frequenzumrichter 3 den Drehstrommotor 2 bestimmungsgemäß ansteuert. Unterschreitet die Ausgangsspannung U_{A} einen unteren Schwellwert U₂, beispielsweise U₂ = 5V, so erzeugt der Schwellwertschalter 5 als binäres Steuersignal S_{HS} einen Low-Pegel, der die Sicherheitsfunktion, insbesondere die sichere Drehmomentabschaltung (Safe-Torque-Off), und somit den sicheren Halt des Drehstrommotors 2 auslöst.

Die Vorrichtung 1 umfasst zudem eine Steuer- und/oder Regeleinrichtung 6, welche die mittels der Wandlerschaltung 4 erzeugte Ausgangsspannung U_{A} an den Schwellwertschalter 5 zur Steuerung des Frequenzumrichters 3 führt, wobei die Ausgangsspannung U_{A} mittels des Schmitt-Triggers 5 in das binäre oder digitale Steuersignal S_{HS}, S_{LS} konvertiert wird. Das Steuersignal S_{HS} aktiviert oder deaktiviert je nach High- oder Low-Pegel die sogenannte High-Side (HS) der üblicherweise aus Leistungshalbleitern (Leistungs- oder Leistungshalbleiterschaltern), insbesondere IGBT's, aufgebauten Brückenschaltung des Frequenzumrichters 3, um den bestimmungsgemäßen Betrieb des Frequenzumrichters 3 zu signalisieren bzw. die Sicherheitsfunktion auszulösen.

Ein gleichermaßen erzeugtes Steuersignal S_{LS}, dass wiederum mittels eines Schwellwertschalters in Form eines Schmitt-Triggers 5 in ein binäres Steuersignal S_{LS} umgewandelt wird, steuert (aktiviert oder deaktiviert) analog die sogenannte Low-Side (LS) der Brückenschaltung des Frequenzumrichters 3. Hierzu umfasst die Vorrichtung 1 zwei gleichartig aufgebaute Steuermodule 1 a, 1 b, die nachfolgend auch als High-Side- oder HS-Steuermodul 1a bzw. Low-Side- oder LS-Steuermodul 1 b bezeichnet werden.

Die Steuer- bzw. Regeleinrichtung 6 umfasst des Weiteren einen Schwellwertschalter 7 in Form vorzugsweise eines Komparators, dem eingangsseitig die Ausgangsspannung U_{A} der Wandlerschaltung 4 zugeführt ist. Der Komparator 7 vergleicht die Ausgangsspannung U_{A} mit einem Maximalwert Uₘₐₓ, der beispielsweise U_{Max} = 60V beträgt. Wird dieser Maximalwert U_{Max} überschritten, so erzeugt der Komparator 7 ausgangsseitig ein Steuer- oder Schaltsignal S_{K}, infolge dessen ein beispielsweise wiederum durch einen Halbleiterschalter oder dergleichen realisierter Schalter 8 die Ausgangsspannung U_{A} an einen Soll-Ist-Vergleicher 9 führt. Bei einer Abweichung des Istwertes Uᵢ der Ausgangsspannung U_{A} von einem Sollwert U_{S}, der beispielsweise der Eingangsspannung U_{E} = U_{S} = 24V entspricht, erzeugt ein Regler 10, vorzugsweise ein PWM-Regler, ein Taktsignal S_{T} zur modifizierten Ansteuerung des Halbleiterschalters V. Die Ansteuerung des Halbleiterschalters V erfolgt dabei über ein galvanisch trennendes Element 11, vorzugsweise in Form eines Optokopplers. Mittels des Reglers 10 wird der Tastgrad der Pulsmodulation, beispielsweise einer Pulsweitenmodulation (PWM) und/oder einer Puls-Pausen-Modulation (PPM), derart eingestellt, dass die Ausgangsspannung U_{A} auf den Sollwert U_{S} eingestellt bzw. reduziert wird.

Der Transformator T wird primärseitig mittels des Halbleiterschalters V periodisch mit der Eingangsspannung U_{E} verbunden und hierzu mit einer bestimmten, konstanten Takt- oder Arbeitsfrequenz betrieben, solange die Ausgangsspannung U_{A} die vorgegebene Maximalspannung U_{Max} unterschreitet. Erst bei Überschreiten dieser Maximalspannung U_{Max} setzt die Steuerung bzw. Regelung über den Schwellwertschalter oder Komparator 7 ein, so dass durch Änderung der Takt- bzw. Arbeitsfrequenz des Halbleiterschalters V die Energieübertragung über den Transformator T verringert und die Ausgangsspannung U_{A} auf die vorgegebene Sollspannung U_{S} geregelt oder gesteuert wird. Mittels der Steuer- bzw. Regeleinrichtung 6 und der Wandlerschaltung 4 ist somit ein sicherer Betrieb der Vorrichtung 1 auch bei einer vergleichsweise hohen Eingangsspannung U_{E} von größer oder gleich 60V ohne Beeinträchtigung der geforderten Sicherheitsfunktion der elektrischen Maschine 2 gegeben.

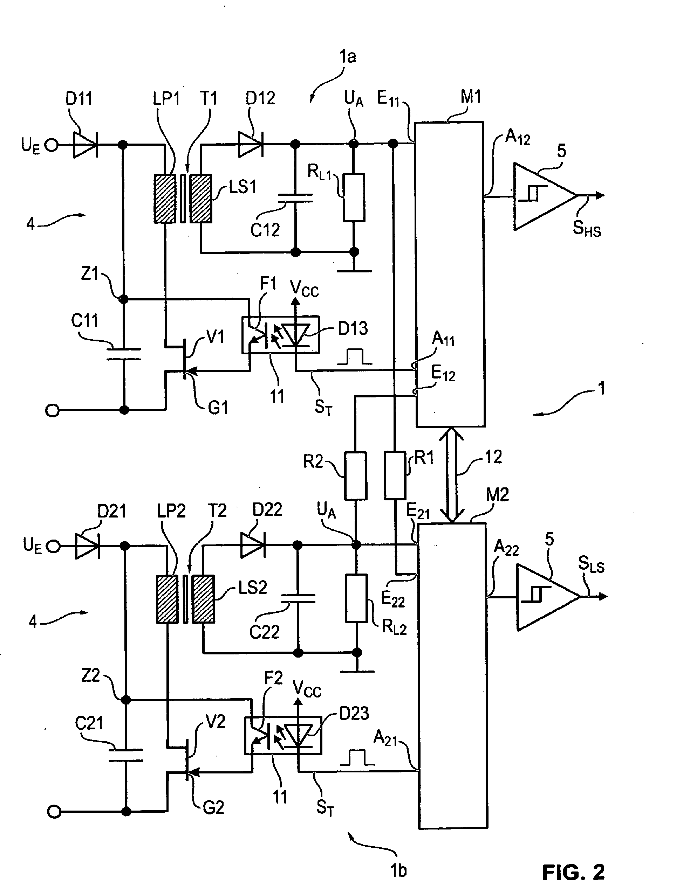

Fig. 2 zeigt einen bevorzugten Aufbau der Wandlerschaltung 4. Dieser ist ausgangsseitig an einen Eingang E₁₁ eines Mikroprozessors M1 geführt, in welchem die Funktionalität des Komparators 7 und des Schalters 8 sowie des Vergleichers 9 und des Reglers 10 programmtechnisch realisiert ist. Der Mikroprozessor M1 bildet zusammen mit der vorgeordneten Wandlerschaltung 4 das erste oder HS-Steuermodul 1a der Vorrichtung 1.

Das zweite oder LS-Steuermodul 1 b ist analog aufgebaut und weist wiederum eine redundante, gleichartige Wandlerschaltung 4 und einen entsprechend redundanten Mikroprozessor M2 zur Realisierung der Funktionalität der Steuer- bzw. Regeleinrichtung 6 auf. Über Ausgänge A₁₂, A₂₂ sind die redundanten Mikroprozessoren M1 und M2 zum jeweiligen Schmitt-Trigger 5 geführt, die ihrerseits die binären Steuersignale S_{HS} bzw. S_{LS} am Frequenzumrichter 3 unter Gewährleistung der Sicherheitsfunktion der elektrischen Maschine 2 bereitstellen. Die Funktionalität der Schmitt-Trigger 5 kann ebenfalls in die Mikroprozessoren M1, M2 integriert sein.

Die Mikroprozessoren M1, M2 sind miteinander über Widerstände R1 bzw. R2 gekoppelt. Weitere Kopplungen der Mikroprozessoren M1 und M2 sind durch den Pfeil 12 angedeutet, der einen Daten- oder Informationsaustausch zwischen den Mikroprozessoren M1, M2 symbolisiert. Zur Kopplung der Mikroprozessoren M1, M2 sind deren Eingänge E₁₁, E₂₁, über welche die Ausgangsspannung U_{A} der Wandlerschaltung 4 zugeführt wird, mittels der Widerstände R1, R2 zu jeweils einem weiteren Eingang E₁₂, E₂₂ der Mikroprozessoren M1 bzw. M2 geführt.

Bei den gleichartig aufgebauten Wandlerschaltungen 4 ist der Halbleiterschalter V1, V2 der jeweiligen Primärwicklung LP1, LP2 des Transformators T1 bzw. T2 seriell nachgeschaltet. Der vorzugsweise über eine Diode D11, D21 als Verpolschutz an die Eingangsspannung U_{E} angeschlossenen Reihenschaltung aus der jeweiligen Primärwicklung LP1, LP2 und dem Halbleiterschalter V1, V2 ist ein Pufferkondensator C11 bzw. C21 parallelgeschaltet. Der Sekundärspule LS1, LS2 des jeweiligen Transformators T1, T2 ist eine Gleichrichterdiode D12, D22 seriell nachgeschaltet sowie ein Glättungskondensator C12, C22 parallelgeschaltet, dem wiederum der Lastwiderstand R_{L1} bzw. R_{L2} parallel geschaltet ist.

In der Ausführungsform nach Fig. 2 ist die Steuer- und/oder Regeleinrichtung 6 durch eine in die Mikroprozessoren M1, M2 programmtechnisch integrierte Komparator- und Schwellwertschalter-Funktionalität realisiert. Der vorzugsweise als MOSFET ausgeführte Halbleiterschalter V1, V2 ist ansteuerseitig (gateseitig) über den Optokoppler 11 als galvanisch trennendes Element innerhalb der Rückführschleife an einen entsprechenden Taktausgang A₁₁, A₂₂ des jeweiligen Mikroprozessors M1 bzw. M2 geführt. Das erzeugte Taktsignal S_{T} ist - wie symbolisch dargestellt - ein Rechtecksignal, das die Fotodiode D13, D23 des Optokopplers 11 periodisch an eine Versorgungsspannung V_{CC} legt, so dass diese alternierend hell oder dunkel ist. Demzufolge wird der Fototransistor F1, F2 des jeweiligen Optokopplers 11 periodisch ein- oder ausgeschaltet und führt somit den Spannungspegel eines Abgriff Z1, Z2 des Pufferkondensators C11, C21 an den Steuereingang (Gate) G1, G2 des jeweiligen Halbleiterschalters V1 bzw. V2. Demzufolge verbindet der jeweilige Halbleiterschalter V1, V2 die Primärspule LP1, LP2 des Transformators T1 bzw. T2 periodisch mit der Eingangsspannung U_{E}. In Abhängigkeit von der jeweils eingestellten Arbeitsfrequenz bzw. dem steuer- oder regelungstechnisch vorgegebenen Tastgrad wird sekundärseitig des Transformators T1, T2 hinter dem Gleichrichter D12, D22 am Kondensator C12, C22 und am Lastwiderstand R_{L1}, R_{L2} die Ausgangsspannung U_{A} eingestellt, die dem jeweiligen Mikroprozessor M1 bzw. M2 als Eingangsspannung zugeführt ist.

Die anhand des Ausführungsbeispiels nach Fig. 1 beschriebene Funktionalität der Schwellwertschaltung bei Erreichen oder Überschreiten des Maximalwertes U_{Max} der Ausgangsspannung U_{A} bzw. der Eingangsspannung U_{E} sowie die Funktionalität der Takterzeugung für den Halbleiterschalter V1, V2 ist in den Mikroprozessoren M1, M2 als Software oder Algorithmus installiert.

Aufgrund der Redundanz der beiden Steuermodule 1 a und 1 b sowie infolge deren Kopplung und gegenseitiger Überwachung erfolgt die Auslösung der Sicherheitsfunktion stets auch dann, wenn eines der Steuermodule 1 a oder 1 b der Vorrichtung 1 eine Fehlfunktion ausführt oder vollständig ausfällt. Hierdurch ist ein hohes Maß an Eigensicherheit der Vorrichtung 1 und damit insgesamt ein hoher Sicherheitsgrad der Vorrichtung 1 gewährleistet.

Die Erfindung ist nicht auf das vorstehend beschriebene Ausführungsbeispiel beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit dem Ausführungsbeispiel beschriebenen Einzelmerkmale auch auf andere Weise miteinander kombinierbar, ohne den Gegenstand der Erfindung zu verlassen.

### Bezugszeichenliste

- 1: Steuervorrichtung
- 1a: HS-Steuermodul
- 1b: LS-Steuermodul
- 2: Maschine/Drehstrommotor
- 3: Frequenzumrichter
- 4: Wandlerschaltung
- 5: Schwellwertschalter/Schmitt-Trigger
- 6: Steuer-/Regeleinrichtung
- 7: Schwellwertschalter/Komparator
- 8: Schalter
- 9: Soll-Ist-Vergleicher
- 10: PWM-Regler
- 11: Element/Optokoppler
- 12: Daten-Pfeil

- A₁₂ A₂₂: Ausgang
- C11, C21: Pufferkondensator
- C12,C22: Glättungskondensator
- D11, D21: Verpolschutz-Diode
- D12, D22: Gleichrichterdiode
- D13, D23: Photodiode
- E₁₁, E₂₁: erster Eingang
- E₁₂, E₂₂: zweiter Eingang
- F1, F2: Phototransistor
- G1, G2: Steuereingang/Gate
- LP1, LP2: Primärwicklung
- LS1,LS2: Sekundärwicklung
- M1, M2: Mikroprozessor
- R1, R2: Widerstand
- R_{L1}, R_{L2}: Lastwiderstand
- Sₖ: Steuer-/Schaltsignal
- S_{T}: Ansteuersignal
- S_{HS}: High-Side-Steuersignal
- S_{LS}: Low-Side-Steuersignal
- T₁, T₂: Transformator
- U_{A}: Ausgangsspannung
- U_{E}: Eingangsspannung
- Uᵢ: Istwert
- U_{S}: Sollwert
- U_{Max}: Maximalwert
- V₁, V₂: Halbleiterschalter
- Z₁, Z₂: Abgriff

## Patentansprüche

1. Verfahren zur Ansteuerung eines Frequenzumrichter (3) einer elektrischen Maschine (2) mit Sicherheitsfunktion, bei dem aus einer Eingangsspannung (U_{E}) eine potentialgetrennte Ausgangsspannung (U_{A}) für den bestimmungsgemäßen Betrieb des Frequenzumrichters (3) und zur Auslösung der Sicherheitsfunktion erzeugt wird,
**dadurch gekennzeichnet,**
- **dass** die Ausgangsspannung (U_{A}) von einer getakteten Wändlerschaltung (4) mit einem periodisch an die Eingangsspannung (U_{E}) geschalteten Halbleiterschalter (V) erzeugt wird,
- **dass** die Ausgangsspannung (U_{A}) einem Schwellwertschalter (5) zugeführt wird, der ein dem Frequenzumrichter (3) zugeführtes binäres Steuersignal (S_{HS}, S_{LS}) erzeugt, das den Betrieb des Frequenzumrichters (3) aktiviert, wenn die Ausgangsspannung (U_{A}) einen oberen Schwellwert (U₁) überschreitet, und das den Betrieb des Frequenzumrichters (3) zur Auslösung der Sicherheitsfunktion deaktiviert, wenn die Ausgangsspannung (U_{A}) einen unteren Schwellwert (U₂) unterschreitet, und
- **dass** die Ausgangsspannung (U_{A}) einer Steuer- und/oder Regeleinrichtung (6) zugeführt wird, die ein Ansteuersignal (S_{T}) für den Halbleiterschalter (V) derart einstellt, dass die Ausgangsspannung (U_{A}) auf einen Sollwert (U_{S}) reduziert wird, wenn diese einen Maximalwert (U_{Max}) überschreitet.

2. Vorrichtung (1) zur Ansteuerung eines Frequenzumrichter (3) einer elektrischen Maschine (2) mit Sicherheitsfunktion,
- mit einer getakteten Wandlerschaltung (4), die einen Transformator (T) mit primärseitig einem periodisch an eine Eingangsspannung (U_{E}) geschalteten Halbleiterschalter (V) zur Bereitstellung einer potentialgetrennten Ausgangsspannung (U_{A}) und sekundärseitig einen Gleichrichter (D) aufweist,
- mit einem dem Gleichrichter (D) nachgeschalteten Schwellwertschalter (5), dem die Ausgangsspannung (U_{A}) zugeführt ist und der ein dem Frequenzumrichter (3) zugeführtes binäres Steuersignal (S_{HS}, S_{LS}) erzeugt, das den Betrieb des Frequenzumrichters (3) aktiviert, wenn die Ausgangsspannung (U_{A}) einen oberen Schwellwert (U₁) überschreitet, und das den Betrieb des Frequenzumrichters (3) zur Auslösung der Sicherheitsfunktion deaktiviert, wenn die Ausgangsspannung (UA) einen unteren Schwellwert (U₂) unterschreitet, und
- mit einer Steuer- und/oder Regeleinrichtung (6), der die Ausgangsspannung (U_{A})zugeführt ist und welche ein Ansteuersignal (S_{T}) für den Halbleiterschalter (V) einstellt sowie die Ausgangsspannung (U_{A}) auf einen Sollwert (U_{S}) reduziert, wenn diese einen Maximalwert (U_{Max}) überschreitet.

3. Vorrichtung (1) nach Anspruch 2,
**gekennzeichnet durch**
dass die Steuer- und/oder Regeleinrichtung (6) eine mit der Ausgangsspannung (U_{A}) der Wandlerschaltung (4) beaufschlagte Komparator- und Schwellwertschalterfunktion (7, 8) zur Aktivierung des Ansteuersignals (S_{T}) für den Halbleiterschalter (V) aufweist.

4. Vorrichtung (1) nach Anspruch 2 oder 3,
**dadurch gekennzeichnet,**
**dass** die Steuer- und/oder Regeleinrichtung (6) einen Soll-Ist-Vergleicher (9) und einen diesem nachgeschalteten Pulsmodulator (10) zur Einstellung der Arbeitsfrequenz des Halbleiterschalters (V) anhand einer Abweichung der Ausgangsspannung (U_{A}) der Wandlerschaltung (4) von einem Spannungssollwert (U_{S}) umfasst.

5. Vorrichtung (1) nach einem der Ansprüche 2 bis 4,
**dadurch gekennzeichnet,**
**dass** der Halbleiterschalter (V) steuerseitig über ein galvanisch trennendes Element (11), insbesondere einen Optokoppler, mit der Steuer- und/oder Regeleinrichtung (6) verbunden ist.

6. Vorrichtung (1) nach einem der Ansprüche 2 bis 5,
**gekennzeichnet durch**
dass der Steuer- und/oder Regeleinrichtung (6) ein Schmitt-Trigger als Schwellwertschalter (5) zugeordnet ist, dem die Ausgangsspannung (U_{A}) der Wandlerschaltung (4) zur Erzeugung des binären Steuersignals (S_{HS}, S_{LS}) für den Frequenzumrichter (3) zugeführt ist.

7. Vorrichtung (1) nach einem der Ansprüche 2 bis 6,
**gekennzeichnet durch**
dass der Halbleiterschalter (V1, V2) mit der Primärwicklung (LP1, LP2) des Transformators (T1, T2) eine mit der Eingangsspannung (U_{E}) beaufschlagte Reihenschaltung bildet.

8. Vorrichtung (1) nach Anspruch 7,
**dadurch gekennzeichnet,**
**dass** der Reihenschaltung ein Pufferkondensator (C11, C21) parallel geschaltet ist, an den der Halbleiterschalter (V1, V2) steuereingangsseitig über den Fototransistor (F1, F2) eines Optokopplers (11) angeschlossen ist.

9. Vorrichtung (1) nach einem der Ansprüche 2 bis 8,
**gekennzeichnet durch**
dass die Funktionalität der Steuer- und/oder Regeleinrichtung (6), insbesondere deren Komparator- und Schwellwertschalterfunktion (7, 8), in einen Mikroprozessor (M1, M2) integriert ist.

10. Vorrichtung (1) nach Anspruch 9,
**gekennzeichnet durch**
redundante Mikroprozessoren (M1, M2), deren Eingänge (E₁₁, E₂₁) für die Ausgangsspannung (U_{A}) der Wandlerschaltung (4) mit dem jeweils anderen Mikroprozessors (M2, M1) gekoppelt sind.

## Claims

1. Method for the control of a frequency converter (3) of an electrical machine (2) having a safety function, where an electrically isolated output voltage (U_{A}) is generated from an input voltage (U_{E}) for the intended operation of the frequency converter (3) and for the triggering of the safety function,
**characterised in that**,
- the output voltage (U_{A}) is generated by a clocked converter circuit (4) having a semiconductor switch (V) which is intermittently switched to the input voltage (U_{E}),
- the output voltage (U_{A}) is fed to a threshold switch (5), which generates a binary control signal (S_{HS}, S_{LS}) fed to the frequency converter (3), said control signal activating the operation of the frequency converter (3) if the output voltage (U_{A}) exceeds an upper threshold (U₁), and said control signal deactivating the operation of the frequency converter (3) for the triggering of the safety function if the output voltage (U_{A}) falls below a lower threshold (U₂), and
- the output voltage (U_{A}) is fed into a control and/or regulation device (6), which adjusts an activation signal (S_{T}) for the semiconductor switch (V) in such a way that the output voltage (U_{A}) is reduced to a target value (U_{S}) if this exceeds a maximum value (U_{Max}).

2. Device (1) for the control of frequency converter (3) of an electrical machine (2) having a safety function,
- having a clocked converter circuit (4), which has a transformer (T) having a semiconductor switch (V) which is intermittently switched to an input voltage (U_{E}) on the primary side for the provision of an electrically isolated output voltage (U_{A}) and a rectifier (D) on the secondary side,
- having a threshold switch (5) downstream from the rectifier (D), to which the output voltage (U_{A}) is fed and which generates a binary control signal (S_{HS}, S_{LS}) fed to the frequency converter (3), said control signal activating the operation of the frequency converter (3) if the output voltage (U_{A}) exceeds an upper threshold (U₁), and deactivating the operation of the frequency converter (3) for the triggering of the safety function if the output voltage (U_{A}) falls below a lower threshold (U₂), and
- having a control and/or regulation device (6), to which the output voltage (U_{A}) is fed and which adjusts an activation signal (S_{T}) for the semiconductor switch (V) and reduces the output voltage (U_{A}) to a target value (U_{S}) if this exceeds a maximum value (U_{Max}).

3. Device (1) according to claim 2,
**characterised in that**,
the control and/or regulation device (6) has a comparator and threshold switch function (7, 8) charged with the output voltage (U_{A}) of the converter circuit (4) for the activation of the control signal (S_{T}) for the semiconductor switch (V).

4. Device (1) according to claim 2 or 3,
**characterised in that**,
the control and/or regulation device (6) comprises a target-actual comparator (9) and a pulse modulator (10) which is downstream from this for the adjustment of the operating frequency of the semiconductor switch (V) by means of divergence of the output voltage (U_{A}) of the converter circuit (4) from a voltage target value (U_{S}).

5. Device (1) according to one of claims 2 to 4,
**characterised in that**,
the semiconductor switch (V) is connected on the control side to the control and/or regulation device (6) via a galvanic dividing element (11), in particular an optocoupler.

6. Device (1) according to one of claims 2 to 5,
**characterised in that**,
the control and/or regulation device (6) is assigned a Schmitt trigger as a threshold switch (5), to which the output voltage (U_{A}) of the converter circuit (4) is fed for the generation of the binary control signal (S_{HS}, S_{LS}) for the frequency converter (3).

7. Device (1) according to one of claims 2 to 6,
**characterised in that**,
the semiconductor switch (V1, V2) having the primary winding (LP1, LP2) of the transformer (T1, T2) forms a series circuit supplied by the input voltage (U_{E}).

8. Device (1) according to claim 7,
**characterised in that**,
a buffer capacitor (C11, C21) is connected in parallel to the series circuit, to which the semiconductor switch (V1, V2) is connected on the control input side via the photo transistor (F1, F2) of an optocoupler (11).

9. Device (1) according to one of claims 2 to 8,
**characterised in that**,
the functionality of the control and/or regulation device (6), in particular its comparator and threshold switch function (7, 8), is integrated into a microprocessor (M1, M2).

10. Device (1) according to claim 9,
**characterised by**,
redundant microprocessors (M1, M2), whose inputs (E₁₁, E₂₁) for the output voltage (U_{A}) of the converter circuit (4) are linked with the respective other microprocessor (M2, M1).

## Revendications

1. Procédé de commande d'un changeur de fréquences (3) d'une machine électrique (2) avec une fonction de sécurité, d'après lequel à partir d'une tension d'entrée (U_{E}), on produit une tension de sortie (U_{A}) isolée ou séparée galvaniquement pour le fonctionnement conforme approprié du changeur de fréquences (3) et pour le déclenchement de la fonction de sécurité,
**caractérisé**
- **en ce que** la tension de sortie (U_{A}) est produite par un circuit convertisseur (4) cadencé, comprenant un commutateur à semi-conducteur (V) commuté périodiquement à la tension d'entrée (U_{E}),
- **en ce que** la tension de sortie (U_{A}) est amenée à un commutateur de valeur de seuil (5) produisant un signal de commande binaire (S_{HS}, S_{LS}) amené au changeur de fréquences (3), qui active le fonctionnement du changeur de fréquences (3) lorsque la tension de sortie (U_{A}) dépasse une valeur de seuil supérieure (U₁), et qui désactive le fonctionnement du changeur de fréquences (3) pour déclencher la fonction de sécurité, lorsque la tension de sortie (U_{A}) passe en-dessous d'une valeur de seuil inférieure (U₂), et
- **en ce que** la tension de sortie (U_{A}) est amenée à un dispositif de commande et/ou de régulation (6), qui règle un signal de commande (S_{T}) pour le commutateur à semi-conducteur (V) de manière à ce que la tension de sortie (U_{A}) soit réduite à une valeur de consigne (U_{S}), lorsque celle-ci dépasse une valeur maximale (U_{MAx}).

2. Dispositif (1) pour la commande d'un changeur de fréquences (3) d'une machine électrique (2) avec une fonction de sécurité,
- comprenant un circuit convertisseur (4) cadencé, qui présente un transformateur (T) avec, côté primaire, un commutateur à semi-conducteur (V) commuté périodiquement à une tension d'entrée (U_{E}) pour fournir une tension de sortie (U_{A}) isolée ou séparée galvaniquement, et, côté secondaire, un redresseur (D),
- comprenant un commutateur de valeur de seuil (5) monté en aval du redresseur (D), auquel est amenée la tension de sortie (U_{A}), et produisant un signal de commande binaire (S_{HS}, S_{LS}) amené au changeur de fréquences (3), qui active le fonctionnement du changeur de fréquences (3) lorsque la tension de sortie (U_{A}) dépasse une valeur de seuil supérieure (U₁), et qui désactive le fonctionnement du changeur de fréquences (3) pour déclencher la fonction de sécurité, lorsque la tension de sortie (U_{A}) passe en-dessous d'une valeur de seuil inférieure (U₂), et
- comprenant un dispositif de commande et/ou de régulation (6) auquel est amenée à la tension de sortie (U_{A}), et qui règle un signal de commande (S_{T}) pour le commutateur à semi-conducteur (V) et réduit la tension de sortie (U_{A}) à une valeur de consigne (U_{S}), lorsque celle-ci dépasse une valeur maximale (U_{MAX}).

3. Dispositif (1) selon la revendication 2,
**caractérisé**
**en ce que** le dispositif de commande et/ou de régulation (6) présente une fonction de comparaison et de commutateur de valeur de seuil (7, 8) alimentée par la tension de sortie (U_{A}) du circuit convertisseur (4), en vue d'activer le signal de commande (S_{T}) pour le commutateur à semi-conducteur (V).

4. Dispositif (1) selon la revendication 2 ou la revendication 3,
**caractérisé**
**en ce que** le dispositif de commande et/ou de régulation (6) comprend un comparateur valeur instantanée-valeur de consigne (9) et, monté en aval de celui-ci, un modulateur d'impulsions (10), pour régler la fréquence de travail du commutateur à semi-conducteur (V) au regard d'un écart de la tension de sortie (U_{A}) du circuit convertisseur (4) par rapport à une valeur de consigne de tension (U_{S}).

5. Dispositif (1) selon l'une des revendications 2 à 4,
**caractérisé**
**en ce que** le commutateur à semi-conducteur (V) est relié, côté commande, par l'intermédiaire d'un élément (11) de séparation galvanique, notamment un optocoupleur, au dispositif de commande et/ou de régulation (6).

6. Dispositif (1) selon l'une des revendications 2 à 5,
**caractérisé**
**en ce qu'**au dispositif de commande et/ou de régulation (6) est associé, en guise de commutateur de valeur de seuil (5), une bascule de Schmitt à laquelle est amenée la tension de sortie (U_{A}) du circuit convertisseur (4) pour produire le signal de commande binaire (S_{HS}, S_{LS}) pour le changeur de fréquences (3).

7. Dispositif (1) selon l'une des revendications 2 à 6,
**caractérisé**
**en ce que** le commutateur à semi-conducteur (V1, V2) forme avec l'enroulement primaire (LP1, LP2) du transformateur (T1, T2), un circuit série alimenté par la tension d'entrée (U_{E}).

8. Dispositif (1) selon la revendication 7,
**caractérisé**
**en ce qu'**avec le circuit série est monté en parallèle, un condensateur tampon (C11, C21) auquel est raccordé le commutateur à semi-conducteur (V1, V2) du côté commande, par l'intermédiaire du phototransistor (F1, F2) d'un optocoupleur (11).

9. Dispositif (1) selon l'une des revendications 2 à 8,
**caractérisé**
**en ce que** la fonctionnalité du dispositif de commande et/ou de régulation (6), notamment sa fonction de comparaison et de commutation de valeur de seuil (7, 8), est intégrée à un microprocesseur (M1, M2).

10. Dispositif (1) selon la revendication 9,
**caractérisé**
**par** des microprocesseurs redondants (M1, M2), dont les entrées (E₁₁, E₂₁) pour la tension de sortie (U_{A}) du circuit convertisseur (4) sont couplées respectivement à l'autre microprocesseur (M2, M1).
